# EUROPEAN PATENT APPLICATION

(11) **EP 1 811 658 A1**
(43) Date of publication of application: **25.07.2007**
(21) Application number: 06290176.4
(22) Date of filing: 24.01.2006
(51) Int. Cl.: H03F 1/52

(54) **Power amplifier bias protection for depletion mode transistor**

(71) Applicant: Alcatel Lucent, 75008 Paris (FR)
(72) Inventor: Seyfried, Ulrich, 71282 Hemmingen (DE); Wiegner, Dirk, 71409 Schwaikheim (DE)
(74) Representative: Brose, Gerhard

(57) **Abstract**

A power amplifier bias protection for a depletion mode transistor is achieved according to the invention with a threshold voltage adaptation connected to the Gate of the depletion mode transistor. That threshold voltage adaptation controls a supply voltage switch for the Drain of the depletion mode transistor such that when the threshold voltage adaptation measures a voltage applied to that Gate outside a tolerable predefined range, then it activates the supply voltage switch to disconnect the Drain DC feed line. The input of the supply voltage switch is connected to the Drain voltage source of the depletion mode transistor and the output of the supply voltage switch is connected to the Drain DC feed line.

## Description

### Technical field

The present invention relates to an amplifier with a depletion mode transistor. Furthermore, the present invention is related to a method for controlling the Gate-voltage to be applied to a depletion mode transistor from an amplifier. The invention concerns also a terminal for radio telecommunications like a broadband, multi-band or wideband base station or a telecommunications terminal (mobile phone) supporting single- or multistandard operation.

### Background of the invention

To cover different frequency bands and mobile communication standards by a single base station, highly linear and efficient multiband/multistandard capable amplifier modules are required. The problem lies with current silicon-based Laterally Diffused Metal Oxide Silicon LDMOS RF power transistors - which often form the basis of power amplifiers. By use of LDMOS-based power amplifiers, it is very difficult or impossible to achieve RF power i.e. broad-/wideband performance efficiently at the signal purity levels required for cost- and capacity-effective 2.5G and 3G multiband/multistandard applications.

Compound semiconductors based on III-V materials far exceed the physical properties of silicon. Gallium Nitride (GaN) has one of the highest dynamic property, therefore it is one of the most promising compound. Indeed, its capabilities - such as amplifying (with lower distortion) RF signals, withstanding high temperatures, emitting blue and green light - make GaN ideally suited for a wide range of electronic and optoelectronic applications.

More particularly, future complex modulation schemes and air interfaces for mobile wireless communications demand very high linearity power amplifiers, which in turn depend on power transistors with very high compression points, high bandwidth capability, excellent thermal stability and increasingly higher frequency response. These requirements place severe constraints on LDMOS technology. But Metal-Semiconductor Field Effect Transistor like SiC-MESFET technology and even better High Electron Mobility Transistor like GaN-HEMTs can alleviate many of these constraints due to their inherently higher transconductance (which helps linearity), high breakdown voltage supporting increased transistor impedance level and thus a wider bandwidth, good thermal management and higher cutoff frequencies. Therefore, a technology based on these transistors seems to be quite promising particularly for multiband/multistandard capable amplifiers.

Currently used LDMOS transistors require a Gate-voltage > 0 V in order to achieve active operation. They are thus not conductive if e.g. the voltage at the Gate is turned-off. This makes them quite robust against any disturbance of the applied voltage. In contrast to that, SiC-MESFET or GaN-HEMTs are depletion mode transistors. They are highly conductive for zero Gate-voltage. Due to this fact, they are very sensitive to any Gate-voltage disturbance and require suitable protection.

Thus, the depletion mode transistors must be feed with a suitable negative Gate-voltage during operation in order to avoid damage or defect e.g. caused by too high current. Hence, a strict sequence has to be followed, when turning on the amplifier. At first, a sufficient negative Gate-voltage (VG) has to be applied; Afterwards, the Drain supply voltage (VD) can be applied. When turning off the transistor, the sequence has to be followed vice versa. Disregarding this sequence will cause damage or defect to the power transistor, since its channel is open and the device consumes much too high current.

Additionally, the applied negative Gate-voltage should be monitored during operation, in order to avoid damage or defect of the transistor if Gate-voltage drops and leaves the allowed Gate-voltage range, like e.g. 0 V. This could e.g. happen if the Gate-voltage source becomes defect, or the Gate feed resistor (which is often used e.g. for stabilisation of the amplifier) becomes defect.

Silicon LDMOS has steadily carved the largest share of the base station power amplifier market at the expense of technology based on SiC-MESFET or GaN-HEMTs. Silicon LDMOS offers excellent cost/performance ratios in this segment. However, its ability to continue addressing this market in next generation systems is questionable due to its operating frequency, breakdown voltage, power density and bandwidth limitations.

### Summary of the invention

In view of the above, it is an object of the present invention to provide an amplifier suitable for broad-, wide- & multiband power amplifier applications while being also cost effective amongst others by being robust to usual current electrical disturbance.

This object is achieved according to the invention by an amplifier with a depletion mode transistor while a threshold voltage adaptation is connected between the Drain DC supply switch and the Gate of the depletion mode transistor. That threshold voltage adaptation controls a supply voltage switch for the Drain of the depletion mode transistor such that when the threshold voltage adaptation measures a voltage applied to the Gate outside a tolerable predefined range, then it activates the supply voltage switch to disconnect the Drain DC feed line.

In an advantageous embodiment of the present invention, the input of the supply voltage switch is connected to the voltage source of the depletion mode transistor. Furthermore, the output of the supply voltage switch is connected to the Drain DC feed line.

According to an alternative of the present invention, the threshold voltage adaptation is connected to a Radio Frequency Gate matching network via a RF block. The Gate matching network itself is connected to the Gate DC feed. According to another alternative, the Radio Frequency Gate matching network is connected to the Gate DC feed via a resistor. According to a further alternative, the threshold voltage adaptation is connected between the Gate DC feed and the Gate-voltage source without a RF block.

In an advantageous embodiment of the present invention, such depletion mode transistor with the proposed bias circuit control principle build the preamplifier, the driver and/or the final amplifier stage of that amplifier. The amplifiers according to one of the embodiments from the present invention are usually used as an amplifier module for a base station and/or telecommunications terminal.

In a further alternative according to the invention, its object is also achieved by applying a method for controlling the Gate-voltage of a depletion mode transistor from an amplifier, the method comprising the steps of tapping this Gate-voltage to control a supply voltage switch for the Drain of the depletion mode transistor. The method comprises the further step to activate that supply voltage switch according to the tapped Gate-voltage in such a way that the supply voltage switch switches off the DC Drain supply voltage line when the measured Gate-voltage is outside a tolerable predefined range. Finally, the supply voltage switch is deactivated as soon as the measured threshold Gate-voltage is within the tolerable predefined range. According to an advantageous embodiment of the present invention, the measurement of the Gate-voltage for controlling the supply voltage switch is achieved by some threshold voltage adaptation. Latter is used for monitoring the Gate-voltage from which depends if an activation or deactivation of the supply voltage switch is performed.

Advantageous developments of the invention are described in the dependent claims, the following description and the drawing.

### Description of the drawing

An exemplary embodiment of the invention will now be explained further with the reference to the attached drawings in which:
Fig. 1 is a schematic view of an amplifier with an enlarged view of the proposed bias protection principle according to the invention;
Fig. 2 is a schematic view of a base station comprising a power amplifier module according to the invention.

### Detailed description of the preferred embodiment

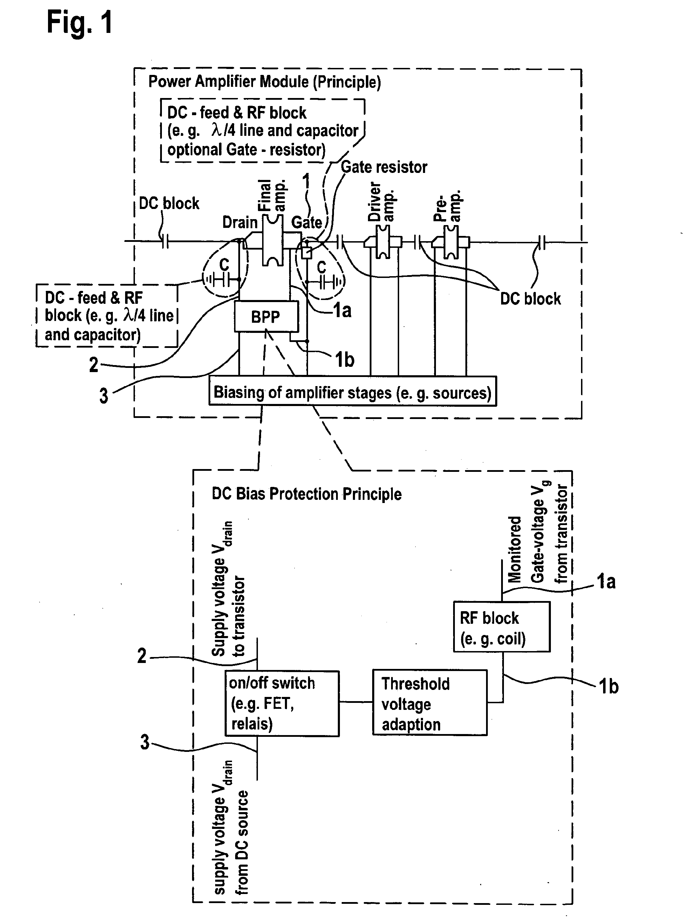

In Fig. 1 is shown a power amplifier module comprising in serial a preamplifier, a driver amplifier, a final amplifier and connected in parallel to their respective input and output a biasing of amplifier stages. It is the final amplifier which is made out of a depletion mode transistor according to the invention in the case shown in Fig. 1. But such a choice is not restrictive and it is by all means possible that it is the preamplifier and/or the driver amplifier which are made out of a depletion mode transistor according to the invention.

In the enlarged view of the Fig. 1 is shown the DC-bias protection principle of the depletion mode transistor according to the invention. A threshold voltage adaptation is connected to the Gate (1) of the depletion mode transistor. Two tapping-alternatives for Gate-voltage monitoring are possible:
a) The input of the threshold voltage adaptation is directly connected to the Gate RF matching network via a RF block (position 1 a). The RF block corresponds to the RF matching network and could well be realised e.g. by a coil. The RF matching network itself is connected to the Gate DC feed via a resistor. That resistor is optional and is e.g. used for stabilisation. This solution takes into account, that the resistor could fail and cause also a fatal voltage drop at the transistor's Gate. This Gate-voltage tapping directly at the RF Gate matching network is especially required, due to the used resistor between the Gate DC feed and the Gate matching network, since this resistor could also become defect and cause a Gate-voltage disturbance.
b) The input of the threshold voltage adaptation is connected to the Gate-voltage DC line between the Gate DC feed and the Gate-voltage source (position 1b). The Gate DC feed itself is directly connected to the Gate matching network without a supplementary resistor. Since the tapping-position is after the Gate DC feed (from transistor's point of view) no additional RF block is required.

Having tapped the current Gate-voltage, a threshold voltage adaptation (realised e.g. by a voltage divider) to the supply voltage switch has to be done. If the current Gate-voltage level drops to too low values, the supply voltage switch breaks the DC Drain supply voltage line (2, 3) and thus protects the transistor against damage or defect, until an allowed Gate-voltage level will be reached again. The input of the supply voltage switch is connected to the voltage source (3). The output of the supply voltage switch is connected to the Drain DC feed (2).

As shown in Fig. 1, the DC feed and RF block can e.g. be realized by using a λ/4 line and a shunt-capacitor. It is used to apply the DC Gate- and Drain-voltage to the transistor. Additionally, it acts as a RF block, which means, that the used capacitor will be transformed to an inductive behaviour at the RF-DC-feed node for a specific frequency (range), which will be defined by the length of the λ/4 line.

A depletion mode transistor when implemented according to an embodiment of the present invention is well protected against Gate-voltage being outside a predefined saved negative bias range. A such saved negative bias range depends directly on the used semiconductor material (e.g. GaN or SiC) as well as on the supplier and their specific process. One possible range (without limitation) for a specific GaN process could be -8 V < VGS < -2V. The lower limit -8 V is also required to avoid any damages of the transistor. But usually, such lower limit is not reached at failure of some resistance or power supply. The threshold voltage adaptation has to be chosen in that way, that the Gate voltage limit corresponds to the threshold voltage/current of the switching element. For example: Gate-voltage limit: -2 V, threshold voltage of switching element: - 4 V; In that case the threshold voltage adaptation has to adapt the Gate-voltage of -2 V to the -4 V.

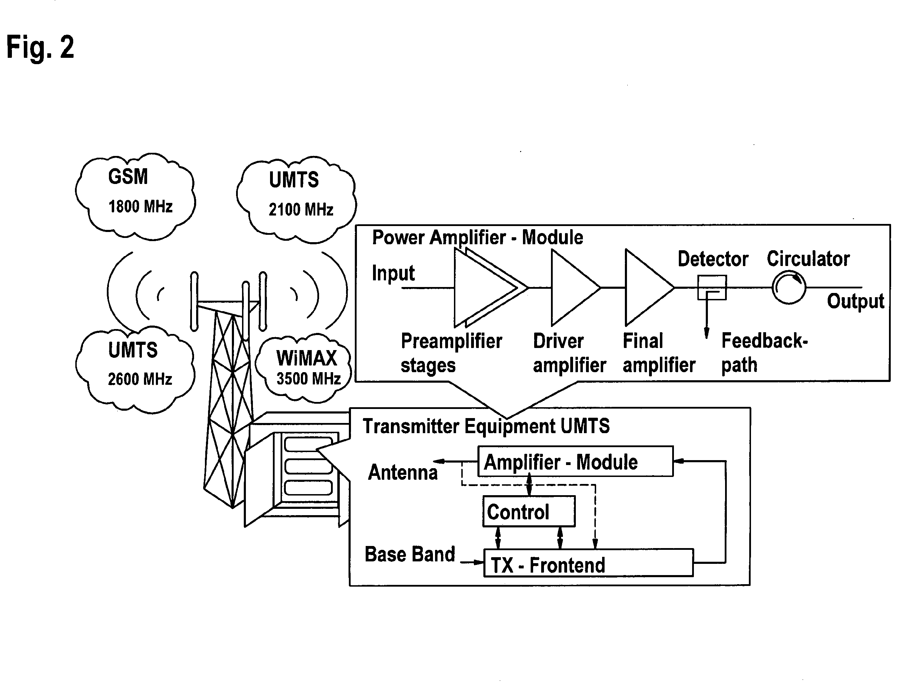

In Fig. 2 is described a schematic embodiment of a terminal for radio telecommunication being a base station with a power amplifier module according to the invention. Such a base station could be a base station supporting a classical 2G radio link using GSM standard at 1800MHz, a 3G link using UMTS standard at 2100MHz or 2600MHz or any other possible mobile phone standard including even the WiMAX standard at 3500MHz. It could be also that the same base station is able to support several of these standards and be used at different frequencies (broadband, multiband, wideband, single-/multistandard). The transmitter equipment of such a base station (in Fig. 2 for the UMTS case but without restricting the invention to that example) comprises in the example figured in Fig. 2 a transmitter front end (TX-Front end), an amplifier module and a control unit. The amplifier module is depicted in an enlarged view above. It comprises besides several amplifier stages (pre-, driver and final stages with the proposed bias protection for depletion mode transistors) at the output usually also e.g. a detector with a feedback path and one or several circulators or isolators. In such a way, the amplifier module of the base station comprises an advantageous bias protection. A similar solution could be implemented at the telecommunications terminal side (e.g. mobile phone) on its transmitter equipment.

## Claims

1. An amplifier with a depletion mode transistor **characterised in that** a threshold voltage adaptation is connected to the Gate of the depletion mode transistor, that threshold voltage adaptation controlling a supply voltage switch for the Drain of the depletion mode transistor such that when the threshold voltage adaptation measures a voltage applied to that Gate outside a tolerable predefined range, then it activates the supply voltage switch to disconnect the Drain DC feed line.

2. The amplifier according to claim 1 **characterised in that** the input of the supply voltage switch is connected to the Drain voltage source of the depletion mode transistor and its output is connected to the Drain DC feed line.

3. The amplifier according to claim 1 **characterised in that** the threshold voltage adaptation is connected to a Radio Frequency Gate matching network via a RF block while the RF Gate matching network itself is connected to the Gate DC feed.

4. The amplifier according to claim 3 **characterised in that** the RF Gate matching network is connected to the Gate DC feed via a resistor.

5. The amplifier according to claim 1 **characterised in that** the threshold voltage adaptation is connected between the Gate DC feed and the Gate-voltage source.

6. The amplifier according to claim 1 **characterised in that** the threshold voltage adaptation comprises a voltage divider.

7. The amplifier according to claim 1 **characterised in that** such depletion mode transistor with the threshold voltage adaptation is the preamplifier and/or the driver and/or the final amplifier stage of that amplifier.

8. A method for controlling the Gate-voltage to be applied to a depletion mode transistor from an amplifier, the method comprising the following steps:
• Tapping the Gate-voltage to be applied to that depletion mode transistor;
• Using that tapped Gate-voltage for controlling a supply voltage switch for the Drain of the depletion mode transistor;
• Activating that supply voltage switch according to the tapped Gate-voltage such that it switches off the DC Drain supply voltage line when the Gate-voltage is outside a tolerable predefined range;
• Deactivating that supply voltage switch as soon as the tapped Gate-voltage is within the tolerable predefined range.

9. The method according to claim 8 wherein the tapping of the Gate-voltage is performed using some threshold voltage adaptation controlling the supply voltage switch according to the measured tapped Gate-voltage.

10. A terminal for radio telecommunications comprising an amplifier according to claim 1.
